Europäisches Patentamt

European Patent Office

Office européen des brevets

(11) Numéro de publication: **0 425 349 A1**

# DEMANDE DE BREVET EUROPEEN

(21) Numéro de dépôt: 90402943.6

(22) Date de dépôt: **19.10.90**

(51) Int. Cl.5: **G11C 19/28, G11C 27/04**

(30) Priorité: **24.10.89 FR 8913908**

(43) Date de publication de la demande:
**02.05.91 Bulletin 91/18**

(84) Etats contractants désignés:
**DE FR GB NL**

(71) Demandeur: **THOMSON COMPOSANTS MILITAIRES ET SPATIAUX**
**50, rue J.P. Timbaud**
**F-92400 Courbevoie(FR)**

(72) Inventeur: **Cazaux, Yvon**

**THOMSON-CSF, SCPI, Cédex 67**
**F-92045 Paris la Défense(FR)**
Inventeur: **Boucharlat, Gilles**
**THOMSON-CSF, SCPI, Cédex 67**
**F-92045 Paris la Défense(FR)**
Inventeur: **Coutures, Jean-Louis**
**THOMSON-CSF, SCPI, Cédex 67**
**F-92045 Paris la Défense(FR)**

(74) Mandataire: **Guérin, Michel et al**
**THOMSON-CSF SCPI**
**F-92045 PARIS LA DEFENSE CEDEX 67(FR)**

(54) **Registre à décalage à haute efficacité de transfert, et procédé de fonctionnement.**

(57) L'invention concerne les registre à décalage du type à transfert de charges. Elle a pour but notamment d'améliorer l'efficacité de transfert des charges.

Dans une forme de réalisation de l'invention, le registre (RD) est du type à entrées parallèles. Il comporte une succession d'étages (EP1 à EP4, EI1 à EI4). Suivant une caractéristique de l'invention, des signaux d'entrées parallèles sont appliqués à un étage (EP1 à EP4) sur K étages, les autres étages (EI1 à EI4) ne recevant de charges que par l'effet des décalages du registre (RD).

Il en résulte que les reliquats (EQ) de charges produits à chaque décalage d'un étage pour une quantité de charges (Q1 à Q4) donnée ne sont pas mélangés à la quantité de charges qui suit.

FIG.2
FIG.2a
FIG.2b
FIG.2c

## REGISTRE A DECALAGE A HAUTE EFFICACITE DE TRANSFERT, ET PROCEDE DE FONCTIONNEMENT

La présente invention concerne les registres à décalage du type à transfert de charges (CCD), et elle concerne aussi les dispositifs de ce type qui fonctionnent en capteurs d'image.

Un registre à décalage à transfert de charges (en abrégé CCD, de l'anglais "Charges Coupled Device") comprend un ou plusieurs étages (jusqu'a plusieurs milliers dans certains cas) formés à l'aide d'un même substrat semiconducteur. Chaque étage est photosensible et il doit être masqué de la lumière si l'on veut le soustraire aux effets de cette dernière. Un étage comprend une ou plusieurs électrodes auxquelles on applique des signaux de tension par rapport au substrat. Ces signaux de tension engendrent dans le substrat des champs électriques qui forment dans le substrat des puits de potentiel et/ou des barrières de potentiel qui permettent de stocker et/ou de transférer des charges suivant un sens de transfert.

Plusieurs étages masqués successifs sont couramment utilisés pour constituer des zones mémoires CCD, ou des registres à décalage CCD utilisés par exemple comme registre de lecture de barrettes linéaires photosensibils CCD ou de matrices photosensibles CCD. Chaque étage peut recevoir une quantité de charges provenant d'un étage précédent et peut transférer ces charges à un étage suivant. Comme mentionné plus haut, s'ils ne sont pas masqués, les étages d'un registre à décalage CCD sont photosensibles et produisent des charges en fonction de leur exposition à un rayonnement utile (lumière visible ou proche du visible). Pour leur utilisation en éléments photosensibles, pendant une période dite d'intégration, les électrodes de ces étages sont portées à un potentiel fixe qui détermine pour chacun un puits de potentiel dans lequel sont stockées les charges produites durant cette période d'intégration.

Ainsi d'une part chaque étage peut servir à stocker des charges, qu'il a engendrées ou non, ou peut constituer un étage de transfert, c'est-à-dire qu'il peut servir à transférer les charges vers un autre étage. D'autre part, chaque étage peut constituer un étage non photosensible ou un étage photosensible selon qu'il est abrité ou non du rayonnement utile de lumière, c'est-à-dire qu'il est masqué ou non masqué.

Dans le cas par exemple d'un détecteur photosensible surfacique CCD, des étages photosensibles (étages non masqués) sont disposés suivant un arrangement matriciel.

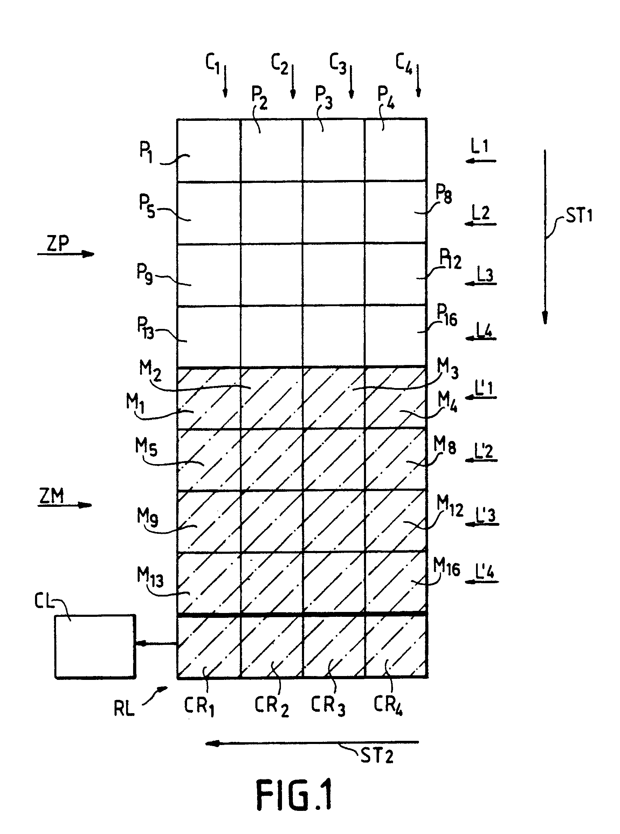

La figure 1 montre schématiquement une architecture classique d'un tel détecteur d'images CCD surfacique. La détecteur d'images comporte des étages P1 à P16 non masqués, c'est-à-dire susceptibles d'être exposés à un rayonnement utile de lumière. Ces étages photosensibles P1 à P16 constituent chacun un point élémentaire d'images ou pixels, et ensemble ils forment une zone photosensible ZP. Ils sont disposés en ligne L1 à L4 et en colonnes C1 à C4, et pour simplifier la figure 1 et la description, seulement quatre lignes et quatre colonnes de ces pixels P1 à P16 sont représentées, ce qui limite à 16 le nombre de ces étages photosensibles ou plxeis. Mais bien entendu, il est courant d'avoir beaucoup plus ou même moins de ces colonnes et/ou de ces lignes.

La zone photosensible ZP est prolongée, dans le sens des colonnes C1 à C4, par une zone mémoire ZM de type CCD elle-même suivie d'un registre de lecture RL constitué d'un registre à décalage CCD. La zone mémoire ZM et le registre de lecture sont constitués d'étages non photosensibles, c'est-à-dire qu'ils sont protégés du rayonnement utile par un écran (symbolisé sur la figure 1 par des hachures obliques en traits pointillés). Dans l'exemple représenté, la zone mémoire ZM comporte un même nombre d'étages que la zone photosensible ZP, soit 16 étages non photosensibles M1 à M16 qui forment quatre lignes supplémentaires $L'1$ à $L'4$. Chaque étage M1 à M16 non photosensible constitue une case mémoire attribuée à un pixel P1 à P16 donné appartenant à la même colonne C1 à C4.

Le fonctionnement d'un tel dispositif est bien connu :
- en supposant que la zone photosensible ZP soit éclairée en permanence par le rayonnement de lumière utile, des charges (représentant un signal utile) produites par chacun des pixels P1 à P16 ou étages photosensibles sont stockées dans un puits de potentiel de stockage (non représenté) propre à chaque pixel, pendant la période d'intégration durant laquelle les tensions appliquées aux électrodes (non représentées) de chacun des étages photosensibles sont fixes. D'autre part, durant la période d'intégration, des charges contenues dans les mémoires M1 à M16 sont transférées simultanément de lignes $L'1$ à $L'4$ en lignes jusqu'au registre de lecture RL et sont transférées dans les cases ou étages CR1 à CR4 correspondantes de ce dernier. Entre chaque transfert d'une ligne $L'1$ à $L'4$ à une ligne suivante jusque dans le registre de lecture, les charges déjà stockées dans les cases CR1 à CR4 de ce dernier, sont transférées pour être lues vers un circuit de lecture CL. Le transfert des charges au niveau du registre de lecture RL s'effectue dans le sens de ce dernier vers le circuit de lecture CL comme montré par une flèche ST2, alors que le transfert des charges dans la zone mémoire ZM s'effectue dans le sens de cette dernière vers le registre de lecture comme montré par une flèche repérée ST1. Ces transferts de charges sont accomplis de manière traditionnelle sous l'effet de signaux de transfert (non représentés) constitués de créneaux de tension cyclique ayant des phases différentes qui sont appliqués aux cases ou étages du registre de lecture RL et de la zone mémoire ZM.

- Dans une phase suivante du fonctionnement, toutes les cases ou étages mémoires de la zone mémoire ZM ayant été vidées, les charges produites et stockées au niveau de chaque étage photosensible P1 à P16 sont transférées dans un étage mémoire M1 à M16 correspondant, appartenant à une même colonne ; le transfert de ces charges s'effectuant suivant les colonnes dans le sens représenté par la flèche ST1. En prenant pour exemple la première colonne C1, les charges contenues au treizième pixel P13 sont transférées à la treizième case mémoire ou étage mémoire M13, en passant successivement par la première, la cinquième et la neuvième cases mémoires, pendant que d'une manière semblable les charges initialement contenues au premier, cinquième et neuvième pixels P1, P5, P9 sont transférées respectivement à la première, cinquième et neuvième cases mémoires M1, M5 et M9. Dans le même temps, des opérations semblables sont réalisées au niveau des colonnes C2, C3, C4. Il est à noter que dans cette phase, des signaux de transfert sont appliqués simultanément aux étages photosensibles ou pixels et aux étages non photosensibles de la zone mémoire ZM. Il est à noter que ces signaux de transfert sont identiques pour les deux types d'étages photosensibles ou non, et que ces signaux comportent des phases différentes, le transfert s'effectuant de façon classique en mode biphase, en trois phases, quatre phases ou davantage (généralement chaque étage comporte autant d'électrodes qu'il y a de phases). Les charges ayant été transférées dans la zone mémoire ZM, une nouvelle période d'intégration débute et de nouvelles charges sont engendrées et stockées au niveau de chacun des pixeis P1 à P16.

L'architecture et le fonctionnement résumés ci-dessus sont bien connus et sont largement utilisés. Ils sont montrés uniquement à titre d'exemple, car de nombreuses autres agencements sont utilisés, par exemple qui n'utilisent pas de zones mémoires.

Néanmoins, parmi les points qui sont communs à tous ces dispositifs CCD, on peut noter le fait que les étages peuvent être utilisés avec des signaux d'entrées parallèles ou non. Ainsi des étages à entrée parallèle sont constitués par les cases CR1 à CR4 du registre de lecture RL, du fait que, d'une part, les charges (signaux utiles) contenues dans ces cases sont transférées d'une case à la suivante vers le circuit de lecture CL, et que, d'autre part, ces charges ont été transférées dans ces mêmes cases depuis une colonne C1 à C4 suivant le sens de transfert ST1, ce qui représente les entrées parallèles, ces charges étant alors des signaux utiles d'entrée parallèle. A l'opposé, les étages qui constituent les cases mémoires M1 à M16 constituent dans l'exemple non limitatif représenté, des étages sans entrée parallèle et sont uniquement des étages à entrées et sorties séries puisqu'ils ne reçoivent des charges ou informations que dans le sens des colonnes.

Par contre, les étages photosensibles P1 à P16 peuvent transférer des charges ou signaux utiles d'un étage à un étage suivant dans le sens des colonnes C1 à C4, mais ils peuvent aussi recevoir une autre information ou signal utile sous forme de lumière, par leur surface photosensible qui constitue ainsi une entrée parallèle.

Il est à noter en outre que dans la phase de transfert, les colonnes C1 à C4 fonctionnent comme un registre à décalage.

Les montages ci-dessus décrits présentent des défauts parmi lesquels certains sont dus à des phénomènes qui ont leur origine aussi bien dans la période d'intégration de charges que dans la période de transfert de charges. Parmi ces phénomènes néfastes au fonctionnement, on peut citer notamment :

- une diffusion des porteurs qui sont engendrés en dehors des zones de charges d'espaces de pixels, pendant la période d'intégration : lorsque la longueur d'onde des photons est suffisamment élevée, ils libèrent des électrons en dehors des zones de charges d'espaces situées sous les électrodes des pixels ou étages photosensibles illuminés. Ces charges ne sont soumises à aucun champ électrique et elles diffusent en partie vers les pixels ou étages voisins, d'où résulte une dégradation de la résolution du capteur d'images.

- Un autre phénomène a pour effet de dégrader l'efficacité de transfert des charges, lors du transfert d'un étage CCD vers l'étage suivant : lors du transfert d'une quantité de charges contenues dans un puits de potentiel vers un second puits de potentiels appartenant à un étage suivant, la quantité de charges n'est qu'incomplètement transférée vers le second puits de potentiel, c'est-à-dire qu'un reiiquat de cette quantité de charges subsiste dans le premier puits de potentiel, il en résulte un mélange d'informations entre deux étages adjacents, du fait de ce reliquat laissé en arrière. Cet effet est particulièrement prononcé dans les CCD du type à transfert en surface, ou lorsque la température est très basse (notamment en dessous de 100 ° K).

- On peut signaler aussi un effet de diaphotie ou intermodulation appelé aussi du terme anglais "smearing", notamment pour les capteurs CCD fonctionnant en mode de type transfert de trames (architecture semblable à celle de la figure 1) : lors du transfert des charges de la zone image vers la zone mémoire, les charges sont transférées dans le sens des colonnes d'un étage photosensible à un étage photosensible suivant c'est-à-dire d'un pixel à un pixel suivant, alors que le flux lumineux incident (rayonnement utile) continue à être focalisé sur la zone photosensible. Il en résulte une intégration brève de charges pendant le transfert, ces charges produites pendant le transfert à des pixels donnés étant ajoutées à des charges produites pendant la période d'intégration à des pixels différents. Cet effet parasite créée un bruits fixe, bruit fixe qui peut être particulièrement gênant si le rayonnement utile est filtré avec des filtres optiques de bandes spectrales différentes (spectroradiomètre) suivant les lignes de pixels.

La présente invention a pour but de réduire de manière importante tous ces effets indésirables, en proposant un agencement nouveau qui peut être appliqué à tout registre à décalage à entrées parallèles et sortie série de type CCD.

Selon l'invention, un registre à décalage du type à transfert de charges auquel sont appliqués des signaux d'entrées parallèles, comportant n étages successifs, chaque étage recevant une charge provenant d'un étage précédent et transférant cette charge à un étage suivant, est caractérisé en ce que, sur au moins une fraction de la longueur du registre à décalage, les signaux d'entrées parallèles sont appliqués uniquement à des étages à entrée parallèle appelés étages principaux, les autres étages étant appelés étages intermédiaires, deux étages principaux consécutifs étant séparés par au moins un étage intermédiaire.

Par étage à entrée parallèle, nous entendons définir un étage CCD dont le fonctionnement est prévu pour transférer une charge qu'il peut recevoir de deux directions différentes, comme c'est le cas des étages d'un registre à décalage classique du type à entrées parallèles et sortie série ; ou bien dont le fonctionnement est prévu pour, d'une part, transférer des charges qu'il reçoit d'un autre étage et, d'autre part, pour transférer des charges qu'il a produit lui-même comme dans le cas des étages non masqués (étages photosensibles).

L'invention concerne aussi un procédé de fonctionnement d'un registre à décalage qui permet d'améliorer les transferts en réduisant le mélange de charges résiduelles et de charges utiles entre les étages successifs du registre. Ce procédé est applicable aux registres à entrée parallèle comme aux registres à entrée série.

Le procédé selon l'invention consiste à utiliser un registre à décalage à k fois N cases, k et N chacun supérieur ou égal à 2, à appliquer M paquets de charge d'entrée au registre, et à effectuer k fois N décalages pour transférer A une sortie série du registre les N paquets de charge d'entrée. Dans le cas d'un registre à entrées parallèles, on applique les paquets de charge à une case sur k, les autres ne recevant de charges que par l'effet des décalages du registre. Dans le cas d'un registre à entrée série, on applique un paquet de charges à l'entrée une fois tous les k décalages.

L'invention sera mieux comprise, et d'autres avantages qu'elle procure apparaîtront à la lecture de la description qui suit, faite à titre d'exemple non limitatif en référence aux figures annexées, parmi lesquelles :

la figure 1 illustre l'architecture et le fonctionnement d'un dispositif photosensible à transfert de charges de type connu ;
- la figure 2 est une vue en coupe le long d'un registre à décalage CCD conforme à l'invention ;
- les figures 2a, 2b et 2c montrent des profils de potentiels en relation avec la structure de la figure 2 ;
- la figure 3 est une vue en coupe d'une succession d'étages CCD dans une zone photosensible ;
- la figure 3a illustre des profils de potentiels en relation avec la structure de la figure 3.

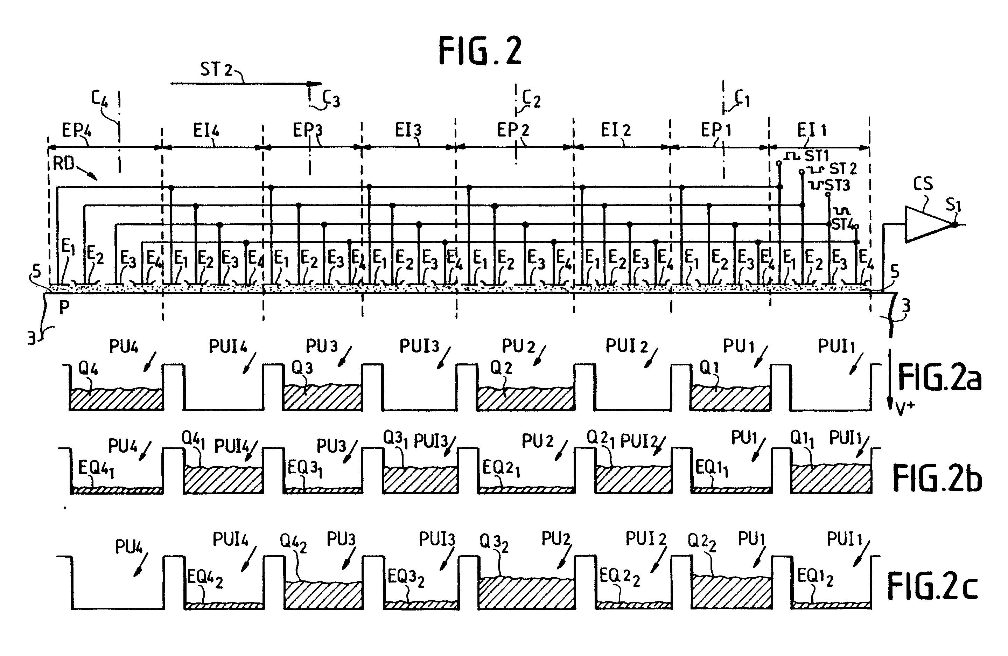

La figure 2 montre des étages CCD d'un registre à décalage RD à entrées parallèles et sortie série conforme à l'invention qui, dans l'exemple non limitatif décrit, constitue un registre de lecture dont la fonction est semblable à celle qui est assurée par le registre de lecture RL montré à la figure 1. Le registre à décalage RD conforme à l'invention est représenté par une vue en coupe parallèlement à un sens de transfert des charges ST2 qui est symbolisé sur la figure par une flèche ST2.

Le registre à décalage est formé sur un substrat 3 dopé de type P par exemple. Il est formé par un registre à décalage et suivi, dans le sens de transfert des charges ST2, par un circuit de sortie CS partiellement représenté par un amplificateur 16. Le registre à décalage RD comporte un nombre n d'étages à entrée parallèle, appelés étages principaux dans la suite de la description, n étant au moins égal à 2. Dans l'exemple non limitatif décrit, le registre à décalage RD comporte quatre de ces étages principaux EP1, EP2, EP3, EP4, mais bien entendu dans l'esprit de l'invention, il pourrait en comporter davantage.

Selon une caractéristique de l'invention, chaque étage principal EP1 à EP4 est suivi, suivant le sens de transfert ST2, d'au moins un étage appelé étage intermédiaire EI1 à EI4 auquel aucun signal ou information n'est transmis par une entrée parallèle. Dans l'exemple non limitatif de la description, pour simplifier cette dernière et la figure 2, seulement un étage intermédiaire EI1 à EI4 a été représenté entre deux étages principaux.

Les étages principaux EP1 à EP4 et intermédiaires EI1 à EI4 sont en eux mêmes classiques et conçus d'une même manière. Dans l'exemple non limitatif décrit, ils comportent tous quatre électrodes E1, E2, E3, E4 recevant de manière classique des signaux de transfert respectivement ST1, ST2, ST3, ST4 de phases différentes ; le transfert s'effectuant par exemple selon un mode à quatre phases. Ces électrodes E1 à E4 étant formées sur une couche électriquement isolante 5 en $SiO_2$ par exemple, elle-même formée sur le substrat 3.

Suivant une organisation semblable au dispositif montré à la figure 1, chaque étage principal EP1 à EP4 constitue l'étage récepteur final d'une succession d'étages tels que ceux contenus dans les colonnes C1 à C4 montrées à la figure 1. Dans la figure 2, des colonnes semblables existent mais sont situées dans un plan perpendiculaire à celui de la figure, aussi elles ne sont pas représentées mais symbolisées par des lignes parallèles en traits pointillés repérés C1 à C4.

Le fonctionnement du registre de lecture conforme à l'invention est illustré à l'aide des figures 2a, 2b, 2c qui montrent des profils de potentiels établis dans le substrat 3 à des instants différents du fonctionnement ; conformément à l'habitude en matière de dispositif à transfert de charges, les potentiels positifs vont en croissant vers le bas.

La figure 2a montre des puits de potentiel formés sous chacun des étages principaux et intermédiaires EP1 à EP4 et EI1 à EI4, après que des quantités de charges Q1 à Q4 provenant respectivement de colonnes C1 à C4 aient été transférées respectivement dans les étages principaux EP1 à EP4, et avant tout transfert de charges dans le registre à décalage lui-même, c'est-à-dire dans le sens ST2. La figure 2a montre que le premier puits de potentiels principal PU1, créé sous le premier étage principal EP1, contient la première quantité de charges Q1, alors que le premier puits intermédiaire PUI1 créé sous le premier étage intermédiaire EI1 ne contient aucune charge ; d'une même manière les second, troisième et quatrième puits de potentiels principaux PU2, PU3, PU4 contiennent une charge, respectivement Q2, Q3, Q4, alors que les premier, second, troisième et quatrième puits intermédiaire) PUI1, PUI2, PUI3, PUI4 sont vides.

La figure 2b représente les mêmes puits de potentiel que la figure 2a, mais à un instant suivant où les charges ont été décalées d'une case c'est-à-dire transférées d'un étage dans le sens de transfert ST2, en direction du circuit de lecture.

Ayant été décalées d'un étage, les charges Q1, Q2, Q3, Q4 initialement contenues dans les puits de potentiel principaux PU1 à PU4 ont été transférées dans les puits de potentiel intermédiaires PI1, PI2, PI3, PI4 où elles sont repérées respectivement $Q1_1$, $Q2_1$, $Q3_1$, $Q4_1$. Compte-tenu du défaut précédemment mentionné de l'inefficacité de transfert (défaut particulièrement prononcé aux basses températures et dans le cas des transferts de surface), le transfert de ces charges a été incomplet, et l'on retrouve dans chacun des puits principaux PU1 à PU4 un reliquat, respectivement $EQ1_1$, $EQ2_1$, $EQ3_1$, $EQ4_1$.

Dans l'art antérieur où les registres de lecture sont constitués d'une succession ininterrompue d'étages à entrée parallèle, le reliquat de chaque charge initiale est mélangé au principal c'est-à-dire à ce qui reste de la charge initiale qui suit : ainsi par exemple le reliquat $EQ1_1$ serait mélangé avec la quantité de charges $Q2_1$. Avec l'invention au contraire, du fait qu'entre deux étages à entrée parallèle c'est-à-dire étages principaux, existe au moins un étage intermédiaire qui n'a pas reçu de charges lors du transfert dans le registre à décalage RD, ce mélange est évité, et il n'y a pas pollution d'une quantité de charges par une autre.

Il est à remarquer bien entendu, que c'est à chaque transfert d'un étage d'une quantité de charges Q1 à Q4, que cette quantité de charges abandonne dans le puits de potentiel qu'elle quitte un reliquat de charges. Ainsi dans le cas montré à la figure 2a où le transfert a été effectué sur un étage : la quantité de charges contenue dans le premier puits intermédiaire est égal à Q1 (1-EQ1). Aussi, pour reconstituer la quantité de charges Q1 à Q4 initiale, il est nécessaire de faire la somme des charges contenues dans un puits de potentiel principal PU1 à PU4 avec la charge contenue dans le puits de potentiel intermédiaire PI1 à PI4 qui le précède directement (dans le sens ST2 de transfert des charges) ; c'est-à-dire que pour connaître la valeur de la charge Q1 initialement transférée dans le premier puits de potentiel principale PU1, il est nécessaire de faire la somme des charges qui, à l'instant représenté à la figure 2b, sont contenues dans le premier puits de potentiel principal et dans le premier puits de potentiel intermédiaire PU1, PI1.

Il est à noter également que chaque reliquat laisse subsister lui-même, au moment de son transfert, un reliquat dans le puits de potentiel qu'il quitte, mais la valeur de ce reliquat de second ordre peut alors être considérée comme négligeable. Cependant, dans l'esprit de l'invention on peut, pour prendre en compte ce reliquat du second ordre, disposer deux ou plus étages intermédiaires entre deux étages principaux.

La figure 2c illustre le remplissage des puits de potentiel quand les charges ont été transférées d'un étage supplémentaire par rapport à la figure 2b. La quantité de charges $Q1_1$ qui était contenue

dans le premier puits de potentiel intermédiaire PI1 n'est plus dans le registre de lecture, elle a été lue par le circuit de sortie CS, et elle a été remplacée dans ce puits de potentiel par un second reliquat $EQ1_2$ qu'elle a laissé subsister ; lequel second reliquat est ajouté au premier reliquat $EQ1_1$ qui dans l'exemple précédent était contenu dans le premier puits de potentiel principal PU1. De Même les quantités de charges $Q2_1$, $Q3_1$, $Q4_1$ ont été transférées dans un puits de potentiel suivant, respectivement dans les puits principaux PU1, PU2, PU3 où elles sont repérées $Q2_2$, $Q3_2$, $Q4_2$ ; bien entendu elles ont laissé subsister chacune un nouveau reliquat $EQ2_2$, $EQ3_2$, $EQ4_2$ auquel s'est ajouté le reliquat précédent $EQ2_1$, $EQ3_1$, $EQ4_1$.

Ainsi les échantillons ou quantités de charges d'origine injectées dans les étages du registre à décalage RD, ne subissent pas de mélange au cours de leur transfert dans ce registre à la sortie duquel ils sont présents sous forme d'autant de signaux qu'il y a d'étages intermédiaires entre deux étages principaux successifs, de telle sorte qu'ils peuvent être reconstitués. La sortie des signaux (en sortie S1 de l'amplificateur 16) s'effectue à une fréquence moitié de celle de la fréquence de transfert, c'est-à-dire moitié de la fréquence des signaux de transfert appliqués aux électrodes E1 à E4.

Les échantillons ou charges initiales Q1 à Q4 sont reconstitués en sortie suivant la relation qui suit :

Qn (1-NE) + N.EQn = Qn ; où Qn est une quantité de charges donnée ; EQn est un reliquat ou quantité de charges abandonnée dans le transfert d'un étage à un étage suivant par la quantité de charges donnée Qn ; M est le nombre d'étages successivement occupés par la quantité de charges donnée durant son transfert.

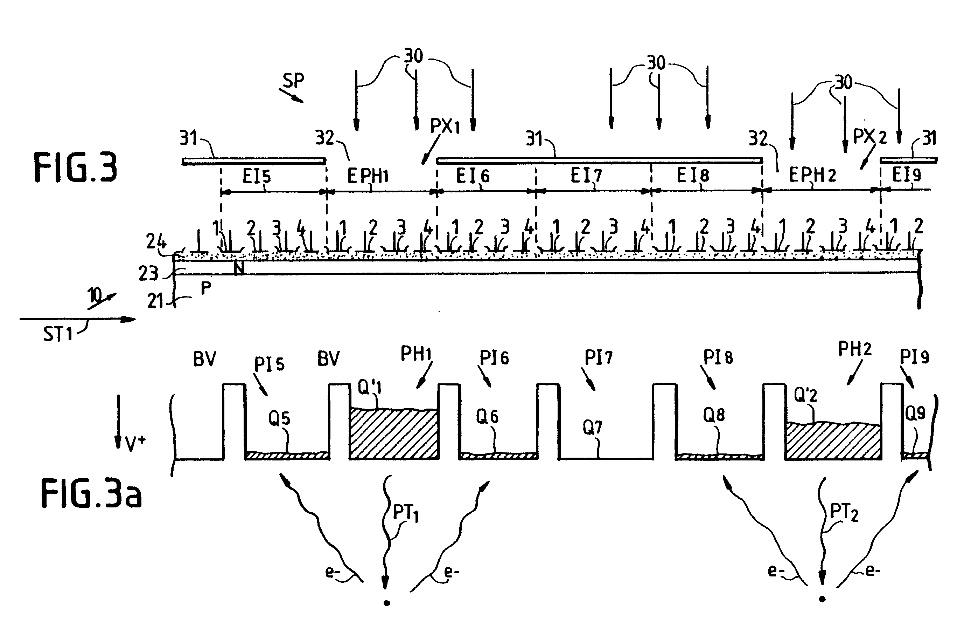

La figure 3 représente une application de l'invention à un détecteur d'images 10 en vue notamment de réduire des défauts de diaphotie.

Le détecteur d'image 10 comporte une zone photosensible SP. La zone photosensible est représentée partiellement par une succession d'étages CCD qui sont montrés par une vue en coupe selon un sens de transfert ST1 de ces étages ; ces étages constituent une colonne formant un registre à décalage qui aboutit à une case ou étage d'un registre de lecture par exemple (non représenté), comme dans le cas de la colonne C1 par exemple montrée à la figure 1.

Le détecteur d'images 10 comprend un substrat semiconducteur 21 en silicium dopé de type P. Le substrat 21 comporte une couche dopée de type N, destinée à constituer un canal enterré 23. Au-dessus du canal enterré 23 est réalisée une couche électriquement isolante 24 en $SiO_2$ par exemple, qui porte une succession d'électrodes E1 à E4, quatre électrodes consécutives E1 à E4 constituant un étage ; le transfert s'effectuant dans un mode à quatre phases, mais bien entendu dans l'esprit de l'invention, la structure peut indifféremment être du type monophasé, biphasé, trois phases, quatre phases ou virtuelle phase, etc...

Suivant une caractéristique de l'invention, la succession d'étages de la zone photosensible SP comprend d'une part, au moins deux étages photosensibles (étages non masqués constituant un étage à entrée parallèle) formant chacun un pixel, et qui sont disposés sur un même axe de transfert de charges c'est-à-dire pouvant assurer un transfert de charges de l'un à l'autre ; elle comprend d'autre part un ou plusieurs étages non photosensibles intercalés entre les deux étages photosensibles.

Dans l'exemple non limitatif représenté à la figure 3, la succession d'étages comprend seulement deux étages photosensibles EPH1, EPH2 constituant chacun un étage principal et représentant chacun un pixel, mais bien entendu la colonne que constitue cette succession d'étages peut comporter un nombre beaucoup plus grand de pixels. Eventuellement un pixel peut être formé à l'aide d'un ou plusieurs étages photosensibles (non masqués) et dans ce dernier cas, un étage photosensible constitue seulement une fraction d'étage principal. De plus, la zone photosensible SP peut comporter comme dans l'exemple de la figure 1, plusieurs colonnes parallèles semblables à la colonne constituée par la succession d'étages montrée à la figure 3, de manière à constituer comme dans la figure 1, des lignes (non représentées) de points photosensibles ou pixels qui s'étendent dans un plan perpendiculaire à celui de la figure 3.

Dans l'exemple non limitatif de la description, trois étages intermédiaires EI6, EI7, EI8 formés d'étages masqués séparent l'un de l'autre les deux étages principaux EPH1, EPH2 ; ces étages intermédiaires sont abrités d'un rayonnement utile de lumière représenté par des flèches 30, par un écran 31.

L'écran 31 est interposé entre la succession d'électrodes E1 à E4 et le rayonnement utile 30, et il comporte des ouvertures 32 situées sensiblement en vis-à-vis des électrodes E1 à E4 des étages qui doivent être rendus photosensibles, c'est-à-dire des étages principaux EPH1, EPH2 qui forment les pixels PX1, PX2. Dans l'exemple non limitatif montré à la figure 3, compte-tenu de la position des ouvertures 32 que comporte l'écran 31, on trouve successivement dans le sens de transfert des charges en partant de la gauche de la figure : un étage intermédiaire EI5 (masqué) suivi d'un étage principal EPH1 (étage non masqué), lui-même suivi de trois étages intermédiaires EI6, EI7, EI8 (masqués) ; puis l'on trouve un étage principal EPH2 (non masqué) suivi d'un étage intermédiaire EI9 partiellement représenté.

Lors de la période d'intégration, les tensions (non représentées) appliquées aux électrodes E1 à E4 sont les mêmes pour les électrodes des étages intermédiaires EI5 à EI9 et pour les étages principaux EPH1, EPH2. Durant la période d'intégration, ces tensions déterminent de façon classique dans le substrat des puits de potentiel.

La figure 3a représente les profils de potentiel engendrés dans le substrat pendant la période d'intégration ; conformément à l'habitude en matière de dispositif à transfert de charges, les potentiels positifs vont en croissant vers le bas.

La figure 3a montre qu'à chaque étage correspond un puits de potentiel PHI, PH2 pour les étages principaux EPH1, EPH2 et PI5 à PI9 pour les étages intermédiaires EI5 à EI9 ; deux puits de potentiel consécutifs étant séparés par une barrière de potentiel BV formée sous une électrode de chaque étage.

Les puits de potentiel PH1, PH2 formés sous les étages principaux ou photosensibles EPH1, EPH2 sont représentés contenant respectivement une première et une seconde quantités de charges $Q'1$, $Q'2$ engendrées par l'exposition de ces étages photosensibles au rayonnement utile 30 qui passe par les ouvertures 32. La figure 3a montre que les puits de potentiel PI5, PI6 et PI8, PI9 qui correspondent aux étages intermédiaires EI5, EI6 et EI8, EI9 contiennent également des charges respectivement Q5, Q6 et Q8, Q9 en quantité plus faible, bien que ces étages intermédiaires ne soient pas exposés au rayonnement utile 30. Ceci provient du fait que des photons (symbolisés sur la figure par des flèches repérées PT1, PT2) qui passent par les ouvertures 32 peuvent pénétrer dans le substrat de façon relativement profonde s'ils ont une longueur d'onde suffisamment élevée, de telle sorte que ces photons libèrent des électrons en dehors des zones de charges d'espaces qui sont formées sous chaque pixel. Par suite, ces charges ne sont soumises à aucun champ électrique, et elles diffusent vers les étages voisins.

Dans l'art antérieur, ces charges qui proviennent d'un phénomène de diffusion sont collectées par des pixels qui sont voisins de celui qui à l'origine reçoit le photon de longueur d'onde élevée. Le mélange de charges produites à des pixels différents peut engendrer une dégradation importante de la résolution de l'image. Dans le cas de l'invention, ces effets sont réduits, voire annulés par la présence d'étages intermédiaires entre les étages photosensibles si ces étages intermédiaires sont en nombre suffisant et/ou disposés sur une longueur supérieure à la longueur de diffusion des porteurs dans le substrat. Dans ce cas en effet, ces charges de diffusion qui échappent à leurs pixels, sont collectées par les étages intermédiaires adjacents et ne polluent pas les pixels voisins. Ceci se traduit par une nette amélioration de la résolution, et tend en outre à limiter aussi l'erreur de détection colorimétrique, erreur qui se produit notamment quand des filtres optiques (non représentés) ayant des bandes spectrales différentes sont disposés au-dessus des différents pixels.

Dans l'exemple non limitatif montré à la figure 3, les deux étages principaux ou étages photosensibles EPH1, EPH2 sont séparés par trois étages intermédiaires EI6, EI7, EI8, de telle façon que ces étages photosensibles sont encadrés chacun sur leurs deux côtés par un étage intermédiaire, les étages EI5, EI6 pour le premier étage photosensible EPH1, et EI8, EI9 pour le second étage photosensible EPH2. L'avantage de cette disposition est qu'elle permet, non seulement d'éviter la pollution d'un pixel par un pixel voisin, mais elle permet aussi de reconstituer la quantité de charges qui appartient à chaque pixel PX1, PX2 en faisant par exemple la somme des charges $Q'1$, Q5, Q6, pour le premier pixel PX1, et $Q'2$, Q8, Q9 pour le second pixel PX2.

Un autre intérêt de la disposition conforme à l'invention, est qu'elle permet de déterminer la valeur de l'effet de diaphotie ou effet dit de "smearing" précédemment mentionné, effet dans lequel notamment se produit une intégration brève de charges pendant le transfert, du fait que la surface photosensible continue à être éclairée par le flux lumineux incident ; d'où il résulte que les quantités de charges durant leur transfert sont augmentées d'une quantité de charges d'origine différente de celles collectées pendant le temps d'intégration. Avec l'invention, le niveau de diaphotie étant connu, il peut être retranché par traitement externe après l'opération de transfert des charges.

A cet effet, au moins un étage intermédiaire supplémentaire est prévu qui est disposé de façon à ne pas être à proximité immédiate d'un étage principal ou étage photosensible. Cet étage intermédiaire supplémentaire peut être par exemple séparé par au moins un autre étage intermédiaire du ou des pixels les plus proches, comme c'est le cas par exemple de l'étage intermédiaire EI7 qui est situé entre les pixels PX1 et PX2 dont il est séparé par un étage intermédiaire EI6 et EI8.

Avec cette disposition, le puits de potentiel PI7 de cet étage intermédiaire supplémentaire EI7 est éloigné des pixels PXI, PX2 afin d'éviter qu'il n'accumule des charges dues à des phénomènes de diffusion survenus à proximité de ces pixels, durant la période d'intégration. Le nombre d'étages intermédiaires EI6, EI8 entre cet étage intermédiaire supplémentaire EI7 et le ou les pIxels PX1, PX2 les plus proches peut être plus grand que dans l'exemple non limitatif montré à la figure 3, l'important étant que cet étage EI7 soit à une distance suffisante des pixels PX1, PX2 pour éviter toute collection de charges dues à une exposition au rayonnement utile 30 durant la période d'intégration (par suite du phénomène de diffusion ci-dessus mentionné).

La quantité de charges Q7 contenue dans le puits de potentiel PI7 est ainsi négligeable ou nulle à la fin de la période d'intégration. Par contre, durant le transfert des charges, la quantité de charges Q7 va occuper une succession de puits de potentiel dont certains correspondent à des étages photosensibles, et à ces positions des charges seront ajoutées à la quantité de charges Q7. La quantité de charges ajoutée correspond à l'effet dit de "smearing" dont le niveau peut ainsi être facilement déterminé.

Il est à remarquer qu'un autre intérêt de la structure représentée à la figure 3 réside dans le fait que, lors de la phase de transfert des charges, on améliore de manière importante l'efficacité du transfert, d'une manière semblable à celle décrite en référence aux figures 2, 2a, 2b et 2c.

Le procédé de fonctionnement qui vient d'être décrit en détail, consistant en résumé à appliquer N paquets de charge d'entrée en parallèle à un registre de K fois N cases exécutant k fois M décalages, est applicable de manière tout à fait intéressante à des registres à entrée série. Dans ce cas, on applique à l'entrée du registre de k fois N cases non pas k fois N signaux (paquets de charge) successifs comme c'est l'habitude mais seulement M signaux. On effectue k décalages entre l'application de deux signaux consécutifs. Il faut donc k fois N décalages pour transférer à la sortie série du registre les N signaux. Le nombre k dans le cas d'un registre à entrée série sera de préférence 2.

**Revendications**

1 - Registre à décalage du type à transfert de charges auquel sont appliqués des signaux d'entrées parallèles, comportant n étages (EP1, EP2, EI1 à EI4) successifs, chaque étage recevant une charge provenant d'un étage précédent et transférant cette charge à un étage suivant, caractérisé en ce que, sur au moins une fraction de la longueur du registre à décalage, les signaux d'entrées parallèles sont appliqués uniquement à des étages à entrée parallèle (EP1, EP2, EPH1, EPH2) appelés étages principaux, les autres étages étant appelés étages intermédiaires, deux étages principaux consécutifs étant séparés par au moins un étage (EI1 à EI4) intermédiaire.

2 - Registre à décalage selon la revendication 1, caractérisé en ce que les signaux d'entrée parallèle sont sous la forme de charges.

3 - Registre à décalage selon la revendication 2, caractérisé en ce que les étages principaux (EP1, EP2) et les étages intermédiaires (EI1 à EI4) sont les étages d'un registre A décalage (RD) utilisé comme registre de lecture.

4 - Registre à décalage selon la revendication 1, caractérisé en ce que les signaux d'entrée parallèle sont sous la forme d'un rayonnement utile (30).

5 - Registre à décalage selon la revendication 4, caractérisé en ce que les étages principaux (EPH1, EPH2) sont des étages photosensibles d'une zone photosensible (SP).

6 - Registre à décalage selon la revendication 5, caractérisé en ce qu'il comporte un écran (31) opaque ou rayonnement utile (30), l'écran (31) étant interposé entre le rayonnement utile (30) et le ou les étages intermédiaires (EI5 à EI9).

7 - Registre à décalage selon l'une des revendications 4 ou 5, caractérisé en ce qu'il comporte en outre au moins un étage intermédiaire (EI7) séparé du ou des étages photosensibles (EPH1, EPH2) par au moins un autre étage intermédiaire (EI6, EI8).

8. Procédé de fonctionnement d'un registre à décalage à transfert de charges caractérisé en ce qu'il consiste à utiliser un registre à décalage à k fois N cases, k et N chacun supérieur ou égal à 2, à appliquer N paquets de charge d'entrée au registre, et à effectuer k fois N décalages pour transférer à une sortie série du registre les N paquets de charge d'entrée.

9. Procédé selon la revendication 8, caractérisé en ce que le registre est à entrées parallèles, et en ce qu'on applique les paquets de charge à une case sur k, les autres ne recevant de charges que par l'effet des décalages du registre.

10. Procédé selon la revendication 8, caractérisé en ce que le registre est à entrée série, et en ce qu'on applique un paquet de charges à l'entrée une fois tous les k décalages.

FIG.1

FIG.2

FIG.2a

FIG.2b

FIG.2c

EP 0 425 349 A1

**FIG.3**

30     30     30

SP

31   32   PX₁   31   32   PX₂   31

EI5   EPH1   EI6   EI7   EI8   EPH2   EI9

1 2 3 4 1 2 3 4 1 2 3 4 1 2 3 4 1 2 3 4 1 2 3 4 1 2

24

23   N

21   P

10

ST1

**FIG.3a**

BV   PI5   BV   PH1   PI6   PI7   PI8   PH2   PI9

Q'1   Q'2

Q5   Q6   Q7   Q8   Q9

V⁺

PT₁   PT₂

e-   e-   e-   e-

# Office européen
## des brevets

# RAPPORT DE RECHERCHE EUROPEENNE

Numéro de la demande

# EP 90 40 2943

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | THE RADIO & ELECTRONIC ENGINEER, vol. 50, no. 5, mai 1980, pages 205-212, Institution of Electronic and Radio Engineers, Londres, GB; D.J. BURT: "Development of c.c.d. area image sensors for 625-line television applications" * Page 206, ligne 25 - page 207, ligne 33; figure 2 * | 1-3,7-9 | G 11 C 19/28 G 11 C 27/04 |
| A | US-A-4 420 773 (TOYODA et al.) * Colonne 4, ligne 42 - colonne 5, ligne 18; figure 5 * | 1-5 | |
| A | US-A-4 696 021 (KAWAHARA et al.) * Colonne 4, ligne 16 - colonne 6, ligne 47; figures 2-4 * | 1,4-6 | |
| A | FR-A-2 620 260 (THOMSON-CSF) * Page 8, ligne 11 - page 11, ligne 16; figures 5-7 * | 4-6 | |

| DOMAINES TECHNIQUES RECHERCHES (Int. Cl.5) |
|---|
| G 11 C 19/00 G 11 C 27/00 |

Le présent rapport de recherche a été établi pour toutes les revendications

| Lieu de la recherche | Date d'achèvement de la recherche | Examinateur |
|---|---|---|
| La Haye | 04 décembre 90 | GEOGHEGAN C.H.B. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention

E : document de brevet antérieur, mais publié à la date de dépôt ou après cette date
D : cité dans la demande
L : cité pour d'autres raisons

& : membre de la même famille, document correspondant